# EUROPEAN PATENT APPLICATION

(11) **EP 1 462 780 A1**
(43) Date of publication of application: **29.09.2004**
(21) Application number: 04251661.7
(22) Date of filing: 23.03.2004
(51) Int. Cl.: G01J 1/42, G03F 7/20

(54) **Apparatus and method for measuring EUV light intensity distribution**

(30) Priority: 28.03.2003 JP 2003091397
(71) Applicant: CANON KABUSHIKI KAISHA, Ohta-ku, Tokyo (JP)
(72) Inventor: Kanazawa, Hajime, Ohta-ku Tokyo (JP); Miyake, Akira, Ohta-ku Tokyo (JP)
(74) Representative: Beresford, Keith Denis Lewis

(57) **Abstract**

A light intensity distribution measuring apparatus for measuring a light intensity distribution in light with a wavelength of 20 nm or smaller emitted from a light source includes plural light intensity detector units each including a mirror and a photoelectric conversion element, and measures the light intensity distribution so that an incident angle of the light incident upon the mirror is a predetermined angle.

## Description

The present invention relates to an extreme ultraviolet ("EUV") light intensity distribution measuring apparatus and method for evaluating an EUV light intensity distribution emitted from an EUV light source for use with a projection exposure apparatus, etc.

In manufacturing such fine semiconductor devices as semiconductor memories and logic circuits in photolithography technology, reduction projection exposure has conventionally been employed with UV light. A minimum critical dimension ("CD") transferable by the projection exposure is proportionate to a wavelength of light for exposure, and inversely proportionate to the numerical aperture ("NA") of a projection optical system. Transfers of finer circuit patterns thus have required light with a shorter wavelength, and the wavelengths of the used UV light have turned from an ultra-high pressure mercury lamp (i-line with a wavelength of about 365 nm) to KrF excimer laser (with a wavelength of about 248 nm) and ArF excimer laser (with a wavelength of about 193 nm).

The photolithography using the UV light, however, has the limits to satisfy the rapidly progressing fine processing of semiconductor devices. Accordingly, there has been developed a reduction projection optical system using EUV light with a wavelength, such as 10 to 15 nm, much shorter than that of the UV light, ("EUV exposure apparatus" hereinafter") for efficient transfers of very fine circuit patterns less than 0.1 µm.

A development of an EUV light source has also been promoted for the EUV exposure apparatus. One example is a laser plasma light source disclosed in Japanese Patent Application publication No. 2002-174700, which irradiates a high-intensity pulse laser beam to a target material in a vacuum chamber, generates high-temperature plasma, and emits EUV light with a wavelength of, *e.g.*, about 13 nm from the emission point. The target material may use a metallic thin film, inert gas, droplets, etc., which are provided in the vacuum chamber by a means such as a gas jet and the like.

An optical element in an optical system for the EUV exposure apparatus utilizes a total reflection mirror for oblique incidence, or a multilayer mirror made of silicon and molybdenum for incident angles close to the normal incidence, because a usual metallic mirror absorbs the EUV light. The multilayer mirror for the normal incidence forms each layer with a thickness that is adjusted to provide large reflectance to the EUV light of a wavelength of 13.5 nm, allowing the projection exposure to use the EUV light with a wave range between 13.365 nm and 13.635 nm around the 13.5 nm among light emitted from the EUV light source.

EUV light from an emission point is condensed onto a condensed point by a spheroid condenser mirror or condensed as collimated light by a rotational paraboloid condenser mirror, introduced into a subsequent projection optical system, and used by an illumination optical system to illuminate a mask in the projection exposure apparatus.

It is critical that EUV light used to illuminate a mask be uniform illumination light, for example, for performance of the projection exposure apparatus, such as resolution. Preferably, an EUV light source supplies EUV light that has uniform light intensity in the light to make the illumination light uniform. However, EUV light supplied from an EUV light source is affected by various factors, such as a plasma shape, a gas concentration distribution in a vacuum chamber, and a shape of the condenser mirror, and does not always provide uniform light intensity. It is therefore necessary to recognize a light intensity distribution within a divergent angle of an EUV light source in advance, and correct the non-uniformity using an illumination optical system, etc.

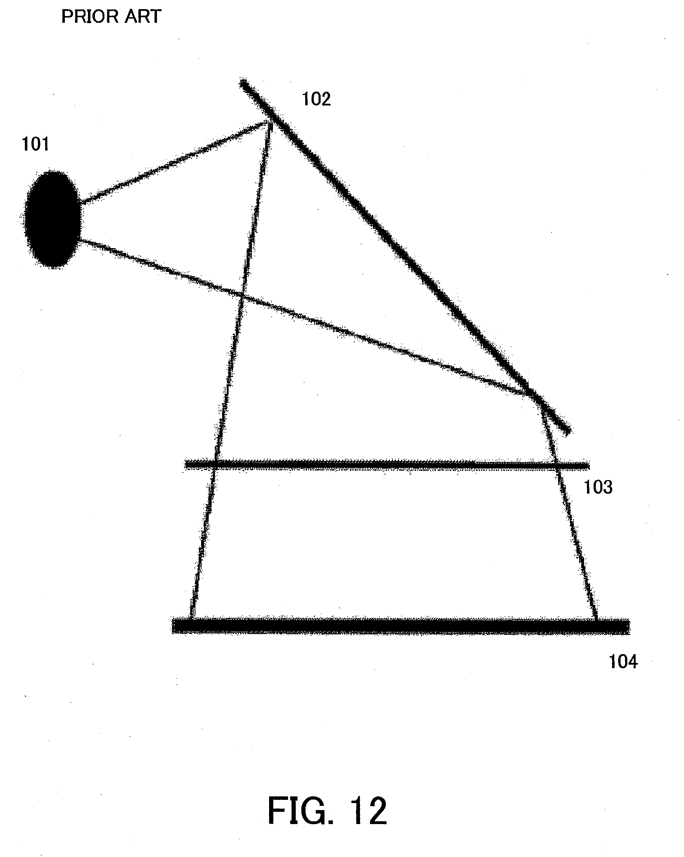

An attainment of this purpose needs an apparatus for measuring the light intensity distribution in the EUV light. Japanese Patent Publication Application No. 2002-175980 discloses technology for measuring the light intensity distribution using an apparatus shown in FIG. 12. In FIG. 12, 101 is a divergent point that diverges light containing EUV light. The light emitted from the divergent point 101 is reflected on a mirror 102, and only the EUV light reaches a CCD array 104 via an EUV filter 103 that transmits only the EUV light. The EUV light from the divergent point 101 reaches different points on a CCD array 104 according to divergent angles, and an output from the CCD by position provides an angular distribution of the EUV light at the divergent point 101.

However, the above apparatus shown in FIG. 12 has the following disadvantages in measuring the light intensity distribution:

A mirror to reflect the EUV light usually uses a multilayer mirror, as discussed. In the multilayer mirror, each layer in the multilayer coating has different apparent thickness viewed with incident light according to incident angles. As a consequence, a wavelength corresponding to the largest reflectance changes according to the incident angles. Thus, EUV light that diverges with a predetermined divergent angle from a condensed point has different incident angles upon the multilayer mirror according to positions, and the EUV light that reaches a light-receiving surface on a CCD has wavelength distributions different according to positions. This causes a problem in that the received light intensity of each position on the CCD cannot provide the accurate light intensity of the EUV light with a wave range between 13.365 nm and 13.635 nm for use with projection exposure.

In addition, a measurement of a light intensity distribution in EUV light needs to clarify a mixture ratio between s-polarized and p-polarized components, but the apparatus shown in FIG 12 cannot do so.

Accordingly, an embodiment of the present invention seeks to provide an EUV light intensity distribution measuring apparatus and method, which can measure a light intensity distribution in the EUV light emitted from an EUV light source, and a mixture ratio between s-polarized and p-polarized components.

A light intensity distribution measuring apparatus for measuring a light intensity distribution in light with a wavelength of 20 nm or smaller emitted from a light source includes plural light intensity detector units each including a mirror and a photoelectric conversion element, and measures the light intensity distribution so that an incident angle of the light incident upon the mirror is a predetermined angle. A light intensity distribution measuring method measures a light intensity distribution in the EUV light using the light intensity distribution measuring apparatus.
FIG. 1 is a sectional view of an EUV light intensity distribution measuring apparatus of a first embodiment according to the present invention.
FIG. 2 is a view showing an arrangement of an EUV light detector unit in the EUV light intensity distribution measuring apparatus of the first embodiment according to the present invention.
FIG. 3 is a sectional view showing a structure of the EUV light detector unit of the first embodiment according to the present invention.
FIG. 4 is a view of an exemplary measurement result in the EUV light intensity distribution measuring apparatus of the first embodiment according to the present invention.
FIG. 5 is a view of an exemplary measurement result in the EUV light intensity distribution measuring apparatus of the first embodiment according to the present invention.
FIG. 6 is a sectional view showing a structure of an EUV light detector unit of a second embodiment according to the present invention.
FIG. 7 is a view showing an arrangement of an EUV light detector unit in the EUV light intensity distribution measuring apparatus of the second embodiment according to the present invention.
FIG. 8 is a view showing one arrangement of an EUV light detector unit in the EUV light intensity distribution measuring apparatus of a third embodiment according to the present invention.
FIG. 9 is a view showing another arrangement of an EUV light detector unit in the EUV light intensity distribution measuring apparatus of a third embodiment according to the present invention.
FIG. 10 is a view of an EUV light intensity distribution measuring apparatus of a fourth embodiment according to the present invention.
FIG. 11 is a sectional view of a sensitivity measuring apparatus in the EUV light detector unit.
FIG. 12 is a conventional exemplary EUV light intensity distribution measuring apparatus.

### FIRST EMBODIMENT

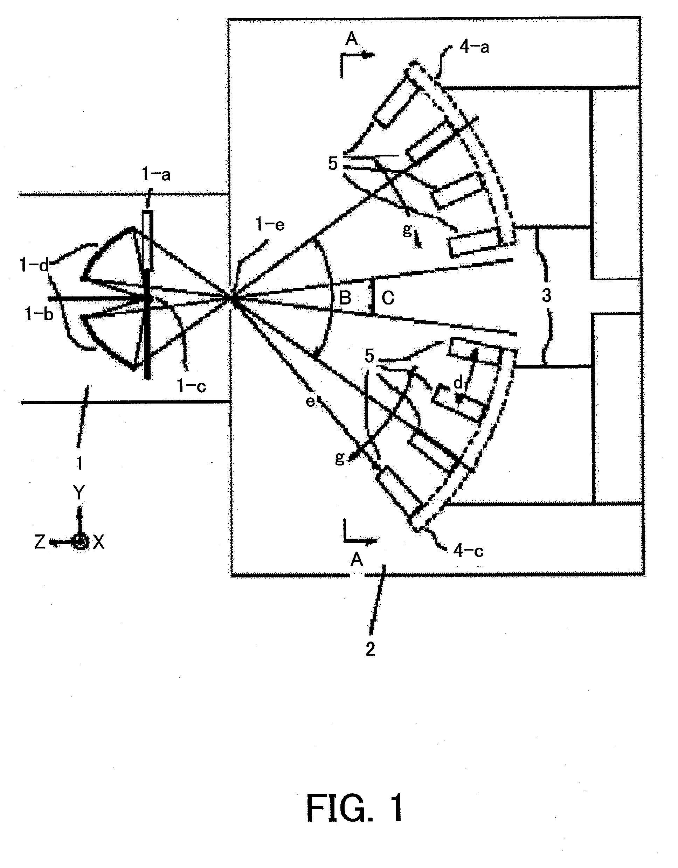

FIG. 1 is a sectional view of the EUV light intensity distribution measuring apparatus of a first embodiment, and an EUV light source that generates the EUV light as an object to be measured. Coordinate axes for use with a description of the present embodiment are, as shown in FIG. 1, an X axis in a direction perpendicular to a paper surface, a Y axis in a longitudinal direction on the paper surface, and a Z axis in a lateral direction on the paper surface. The instant embodiment contemplates an application of an

EUV light intensity distribution measuring apparatus to an EUV light source that condenses the EUV light diverged from a divergent point using a spheroid condenser mirror, and supplies the EUV light source to an exposure apparatus. Similar effects may be obtained when the present invention is applied to an EUV light source that provides a projection exposure apparatus with EUV light that has been diverged from a divergent point and turned to be collimated light by a rotational paraboloid mirror, if an apparatus configuration is properly modified according to a type of the EUV light.

The EUV light source 1 irradiates laser beam 1-b onto a target material supplied from a nozzle 1-a, turns a target material into plasma near an emission point 1-c, and radiates pulsed EUV light. This EUV light is condensed onto a condensed point 1-e by a condenser mirror 1-d, and the condensed point 1-e diverges the EUV light within a solid angle B but not solid angle C.

The EUV light intensity distribution measuring apparatus 2 provides θ stages 4-a to 4-d on a ωZ stage 3 rotatable around the Z axis with respect to the condensed point 1-e, which are rotatable around the condensed point 1-e on a plane that contains the Z axis. Four EUV light detector units 5 are provided at regular intervals of "d" on each θ stage. The θ stages 4-a to 4-d have an arc shape having the same radius from the condensed point 1-e as a center, as shown in FIG. 1, and all the EUV light detector units 5 are positioned distant from the condensed point by an equal distance "e". In addition, all the EUV light detector units 5 face the condensed point 1-e.

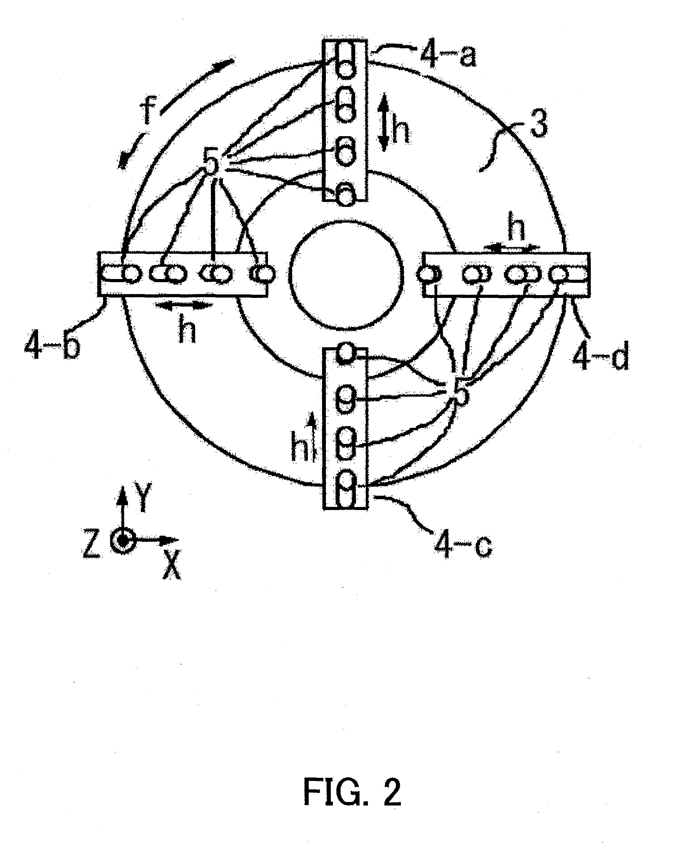

The above structure enables all the EUV light detector units 5 to rotate around the Z axis as shown by an arrow "f" in FIG. 2 via the ωZ stage 3, and rotate along a spherical surface around the condensed point 1-e as shown by an arrow "g" in FIG. 1 or an arrow "h" in FIG. 2 via the θ stages 4-a to 4-d.

The ωZ stage 3 and the θ stages 4-a to 4-d have such sufficient movable ranges that plural EUV light detector units can cover a measurement range. For example, the ωZ stage 3 may be configured to rotate by at least 90°.

The plural EUV light detector units 5 are thus arranged at different positions apart from the condensed point 1-e by approximately the same distance, and movable on the spherical surface around the condensed point, detecting the EUV light intensity distributions radiated in arbitrary directions from the condensed point 1-e.

Since the EUV light is characteristically absorbed by gas, a vacuum pump (not shown) maintains vacuum the inside of the EUV light intensity distribution measuring apparatus 2.

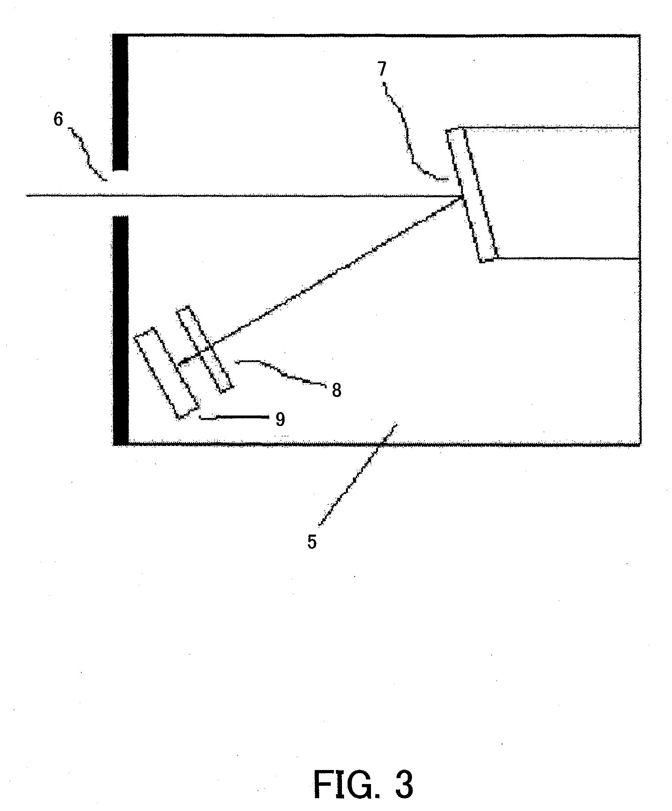

FIG. 3 is a sectional view showing a structure of the EUV light detector unit 5. Each EUV light detector unit has the same structure in the EUV light intensity distribution measuring apparatus 2. The EUV light detector unit 5 reflects the EUV light incident through an aperture 6 on a multilayer mirror 7 that is typically a multilayer coating made of silicon and molybdenum, and measures the light intensity using a photodiode 9 as a photoelectric conversion element, if necessary, via a filter 8 that is configured to absorb light other than the EUV light, such as a zirconium thin film. A CCD that has spatial resolution can be used instead of the photodiode 9. The photodiode 9 outputs a signal corresponding to the light intensity of the EUV light, which is an output of the EUV light detector unit 5. If necessary, the EUV light output detector unit has an amplifier part to amplify or convert an output from the photodiode 9, to form its output.

The multilayer mirror 7 includes a silicon layer and a molybdenum layer that are alternately formed by a known method and respectively have such thicknesses as maximize the reflectance to the EUV light with a wavelength of 13.5 nm for use with the projection exposure. The light from the EUV light source includes not only the EUV light with a wavelength about 13.5 nm but also the EUV light with a wave range between about 10 nm and about 20 nm, the visible light and infrared light. When all of such light is incident upon the photodiode 9, it would be difficult to measure the light intensity distribution used for actual exposure. On the other hand, a reflection on this multilayer film 7 would eliminate light other than the EUV light having a wavelength about 13.5 nm, and enables the light intensity distribution of the target EUV light to be measured. The filter 8 that absorbs light other than the target EUV light is provided for more precise measurements.

A Brewster angle is 42.6° for the EUV light having a wavelength of 13.5 nm for use with the projection exposure, and the reflectance to the p-polarized light becomes small and only the s-polarized component is reflected when the incident angle is close to the Brewster angle. On the other hand, the EUV light detector unit 5 used for the instant embodiment sets an incident angle of the EUV light upon the multilayer film 7 via the aperture 6 to about 10° close to the normal incidence and away from the Brewster angle. Therefore, s-polarized component is seldom reflected selectively and the EUV light detector unit 5 outputs a signal corresponding to the light intensity of the EUV light with a wavelength of about 13.5 nm irrespective of a polarization component ratio. The incident angle is not limited to 10°, but may be about 20° or smaller which does not cause a great difference in reflectance between s-polarized light and p-polarized light.

The EUV light intensity distribution measuring apparatus 2 of the instant embodiment arranges the plural EUV light detector units 5 towards the condensed point 1-e, and measures the light intensity of the EUV light with a certain wavelength with the same sensitivity irrespective of angles of the EUV light, consequently precisely measuring the light intensity distribution in the EUV light radiated from the condensed point 1-e. Similar light intensity distribution measurements may be obtained to this embodiment that uses plural EUV light detector units 5, when a single EUV light detector unit 5 faces the condensed point 1-e and scans the EUV light. On the other hand, when a target material is particularly gas or liquid, the pulsed EUV light generated from the emission point 1-c may be distributed differently according to pulses. One pulse emission time is extremely short or shorter than 1 msec. Therefore, when the EUV light detector unit 5 scans and measures the light intensity distribution, the scattering distribution of the EUV light among pulses superimposes on the original distribution, preventing accurate measurements of an average light intensity distribution of the EUV light as a target to be measured. On the other hand, the sufficient number of EUV light detector units 5 distributed in the EUV light and simultaneous measurements can measure the light intensity distribution of the EUV light for each pulse and the average light intensity distribution of the EUV light.

The EUV light detector unit 5 narrows a range of the EUV light from the condensed point 1-e through the approximately circular aperture 6 as a transmission part of the EUV light, and leads the EUV light to the photodiode 9. This structure restricts an incident angle upon the multilayer mirror 7, and thus narrows a wavelength distribution range of the reflected light, precisely measuring the light intensity distribution of the EUV light having the target wavelength. The instant embodiment sets an angle to about 6° or a solid angle to about 0.086 steradians for the aperture 6 to view the condensed point 1-e in the EUV light detector unit 5. An angle viewed from the aperture 6 to the condensed point 1-e is not limited to this angle, and may about 10° (corresponding to a solid angle of 0.024 steradians) or smaller for desired measurements. A possibly smaller angle viewed from the aperture 6 to the condensed point 1-e is preferable so as to precisely measure the light intensity of the EUV light having a single wavelength, but an angle of about 4° (corresponding to a solid angle of 0.038 steradians) would reconcile the sufficient measurement sensitivity with the monochromatization of the EUV light.

The instant embodiment arranges, as shown in FIG. 2, totally sixteen EUV light detector units 5, four of which are arranged in radially orthogonal directions. Simultaneous and continuous measurements using these sixteen EUV light detector units 5 provide recognitions of the changing light intensity distribution of the emitted EUV pulsed light without moving these sixteen EUV light detector units 5 through the ωθ stage 3 and θ stages 4-a to 4-d. In addition, simultaneous and continuous measurements using these sixteen EUV light detector units 5 provide recognitions of detailed light intensity distribution by moving the ωθ stage 3 and θ stages 4-a to 4-d.

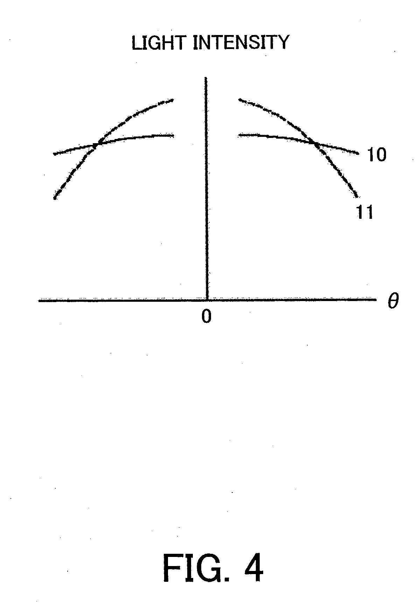

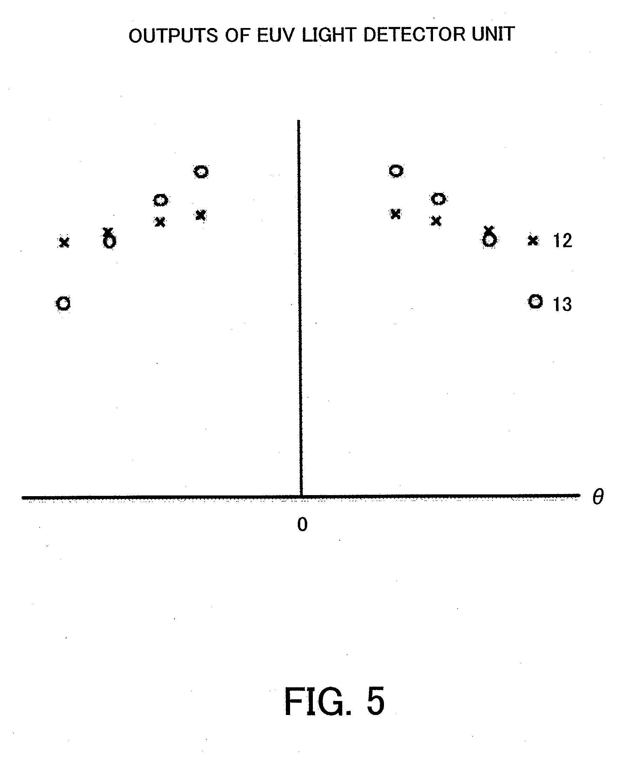

FIGs. 4 and 5 are exemplary graphs of the light intensity distribution of the EUV light obtained from the EUV light intensity distribution measuring apparatus 2, and show a relationship between an angular direction from the Z axis with a center of the condensed point 1-e, and the light intensity of the EUV light of 13.5 nm. For example, the light intensity distributions 10 and 11 are obtained, as shown in FIG. 4, when the measurements associates with movements of the EUV light detector units 5 in a radial direction. Measurements that fix the EUV light detector units 5 provide results shown in FIG. 5, such as x (plots 12) and o (plots 13) as part of the light intensity distribution.

As shown in FIG. 2, the plural EUV light detector units 5 are arranged in a circumferential direction, and thus a polar coordinate gives time variation of the light intensity distribution. Non-coplanar arrangements of the EUV light detector units 5 and divergence center point of the EUV light preferably provides the time variation of the angular distribution.

The thus-structured EUV light intensity distribution measuring apparatus 2 can precisely measure a light intensity distribution of EUV light with a predetermined wavelength in the EUV light radiated from a EUV light source for use with projection exposure.

While this embodiment discusses the measurements of the light intensity distribution within a divergent angle when the EUV light source has a condensed point, the present invention is applicable to the EUV light as collimated light or other shapes, by arranging the EUV light detector unit 5 towards the optical axis direction.

### SECOND EMBODIMENT

The second embodiment discusses an apparatus and method for measuring the light intensity distribution in the EUV light and a mixture ratio between s-polarized and p-polarized components at respective positions in the EUV light through the EUV light detector units 15 different from that in the first embodiment.

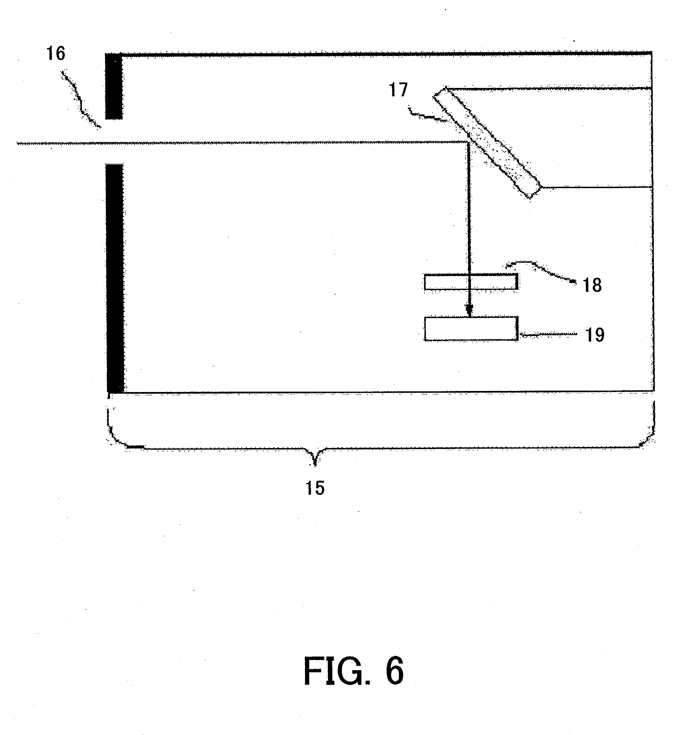

FIG. 6 is a sectional view of an EUV light detector unit 15 for use with the second embodiment. The EUV light detector unit 15 reflects the EUV light incident through an aperture 16 on a multilayer mirror 17 that is typically a multilayer coating made of silicon and molybdenum, and measures the light intensity using a photodiode 19 as a photoelectric conversion element, if necessary, through a filter 18 that is configured to absorb light other than the EUV light, such as a zirconium thin film. The photodiode 19 outputs a signal corresponding to the light intensity of the EUV light, which is an output of the EUV light detector unit 15.

The EUV light detector unit 15 in the instant embodiment sets an incident angle upon the multilayer mirror 17 to be a Brewster angle of 42.6° for the EUV light having a wavelength of 13.5 nm. As a result of that only the s-polarized light is reflected which is the polarized light in a direction approximately perpendicular to the paper surface shown in FIG. 6, the photodiode 19 can measure the light intensity of the s-polarized component.

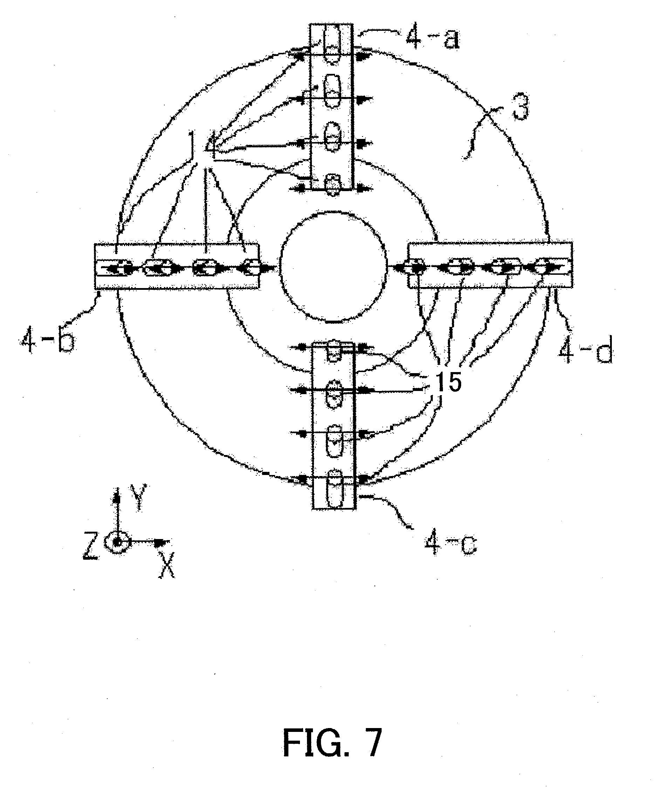

FIG. 7 is a view showing an arrangement of the EUV light detector units 15 on the θ stages 4-a to 4-d. The instant embodiment arranges the EUV light detector units 15 on the θ stages 4-a to 4-d so that all the planes that contain the light reflected by the multilayer mirror 17 are parallel to each other in each EUV light detector unit 15. In other words, for example, a s-polarized light direction detected by each EUV light detector unit 15 is an arrow direction in FIG. 7.

An arrangement of the EUV light detector units 15 as shown in FIG. 7 would measure the light intensity distribution in the EUV light and a mixture ratio between the s-polarized component and the p-polarized component in the EUV light at respective positions.

In other words, for example, each EUV light detector unit 15 measures the light intensity of the EUV light while the ωθ stage 3 is fixed at the position shown in FIG. 7. The light intensity of the EUV light measured at this time is one of a component polarized in the arrow direction shown in FIG. 7. Next, the ωθ stage 3 is rotated by 90°, and each EUV light detector unit 15 again measures the light intensity of the EUV light. The light intensity of the EUV light measured at this time is one of a component polarized in a direction perpendicular to the arrow direction shown in FIG. 7.

Thus, use two EUV light detector units 15 in which the s-polarized directions to be detected are orthogonal can measure a mixture ratio between the s-polarized component and the p-polarized component in the EUV light at respective measurement positions in the EUV light.

### THIRD EMBODIMENT

The third embodiment discusses an apparatus and method for measuring a mixture ratio between the s-polarized component and p-polarized component at respective positions in the EUV light through use of a method different from that in the second embodiment.

The instant embodiment arranges the EUV light detector units 15 on the θ stages 4-a to 4-d so that each EUV light detector unit 15 can be rotated by 90° while the incident direction of the EUV light is maintained constant.

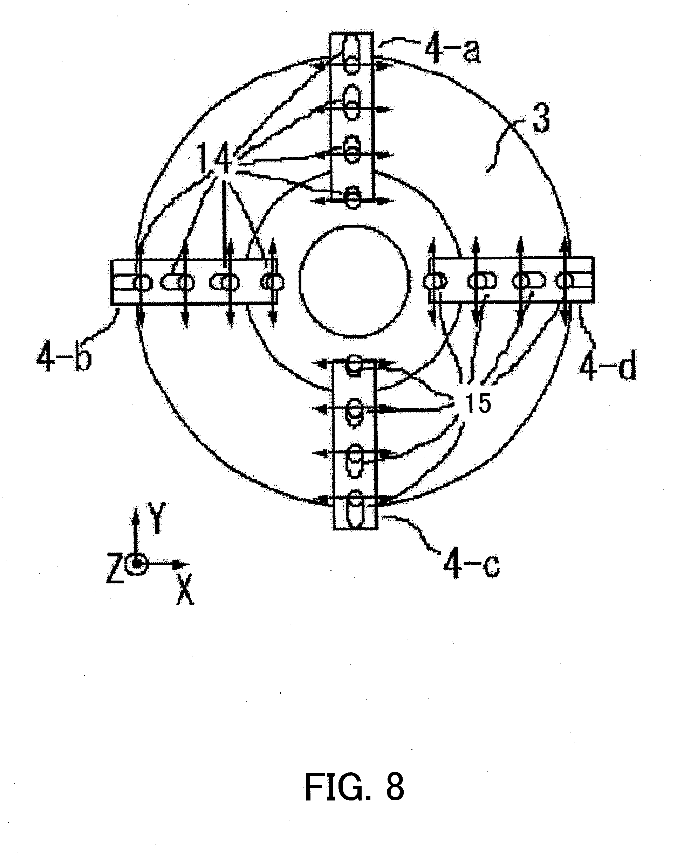

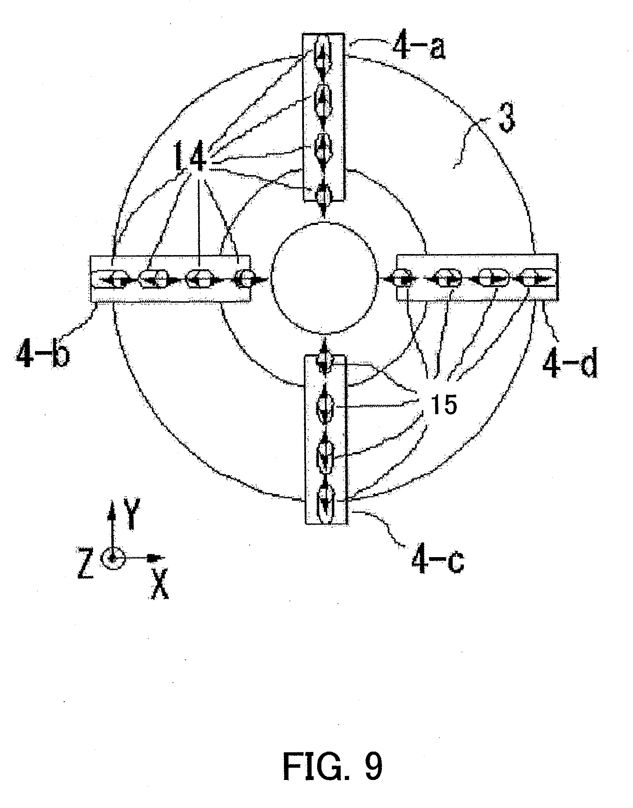

FIGS. 8 and 9 are views before and after each EUV light detector unit 15 arranged on the θ stages 4-a to 4-d is rotated by 90° in the instant embodiment. When each EUV light detector unit 15 is rotated by 90°, the s-polarized light to be detected as shown by an arrow rotates by 90°. While FIGS. 8 and 9 show that EUV light detector units 15 have the aligned s-polarized direction on the θ stages 4-a to 4-d, they may rotate by 90°.

This configuration enables a single EUV light detector unit 15 to measure a mixture ratio between the s-polarized component and the p-polarized component of the EUV light at respective positions in the EUV light, restraining measurement errors due to sensitivities among the EUV light detector units 15.

The EUV light detector unit 15 used for the instant embodiment includes, as shown in FIG. 6, one multilayer mirror 17 that receives the EUV light at a Brewster angle, and one photodiode 19 that measures the reflected light, but may include first and second multilayer mirrors that reflect, in orthogonal direction, the EUV light that is incident at the Brewster angle, and two photodiodes corresponding to these mirrors, so as to measure the light intensities of the s-polarized component and the p-polarized component which are simultaneously detected.

### FOURTH EMBODIMENT

The fourth embodiment arranges the EUV light detector units 5 differently from the first embodiment.

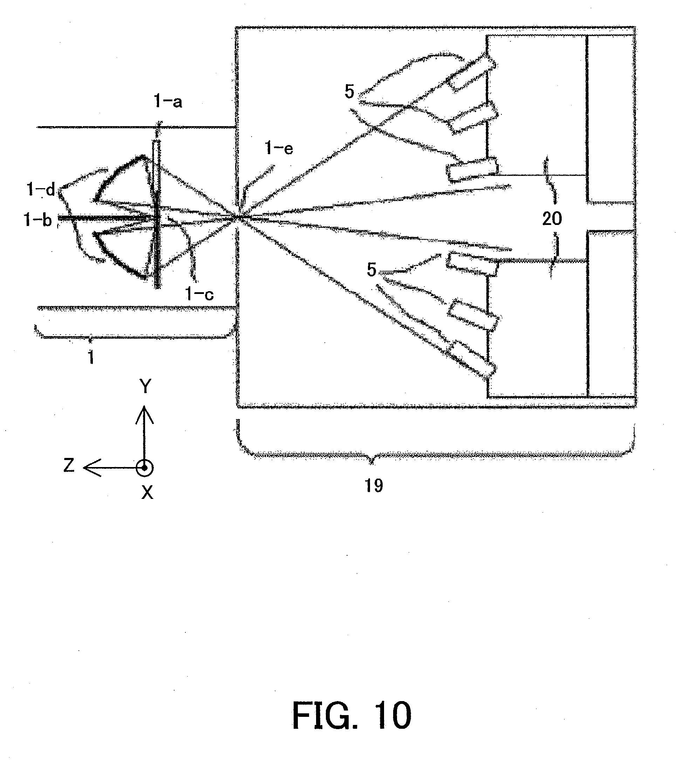

FIG. 10 is a sectional view of an EUV light intensity distribution measuring apparatus 19 of the fourth embodiment, and the EUV light source that generates the EUV light as an object to be measured. The EUV light intensity distribution measuring apparatus 19 of the instant embodiment arranges the EUV light detector units 5 on the ωZ stages 20 on an approximately coplanar surface perpendicular to the Z axis, simplifying the configuration of the first embodiment. The EUV light detector unit 5 may uses a type that houses a multilayer film upon which the EUV light is normally incident, and a type that houses a multilayer film upon which the EUV light is incident at a Brewster angle.

The EUV light detector units 5 are arranged preferably as shown in FIG. 10, when the EUV light radiated from the EUV light source is collimated light or when the EUV light has a condensed point but with a small radiation angle of the EUV light from the condensed point 1-e and a large distance between the EUV light detector unit 5 and the condensed point 1-e.

While FIG. 10 shows that the ωZ stages 20 is rotatable around a line that connects the emission point 1-c and the condensed point 1-e, a rotational shaft of the ωZ stages 20 is not limited to this line as far as it rotates around an optical axis of the EUV light to be measured which is radiated from the EUV light source. An arbitrary rotation would be available according to embodiments of the EUV light source. In this case, it is effective to simultaneously correct an output of the EUV light detector unit 5, which will be described later.

When the EUV light detector units 5 are arranged as shown in FIG. 10 for the EUV light from the EUV light source with a condensed point, a problem occurs when distances between respective EUV light detector units 5 and the condensed point are different. In this case, the light intensity distribution in the EUV light can be precisely measured by correcting an output of each EUV light detector unit 5 using a fact that the light intensity of the EUV light attenuates in proportion to a square of a distance of divergence.

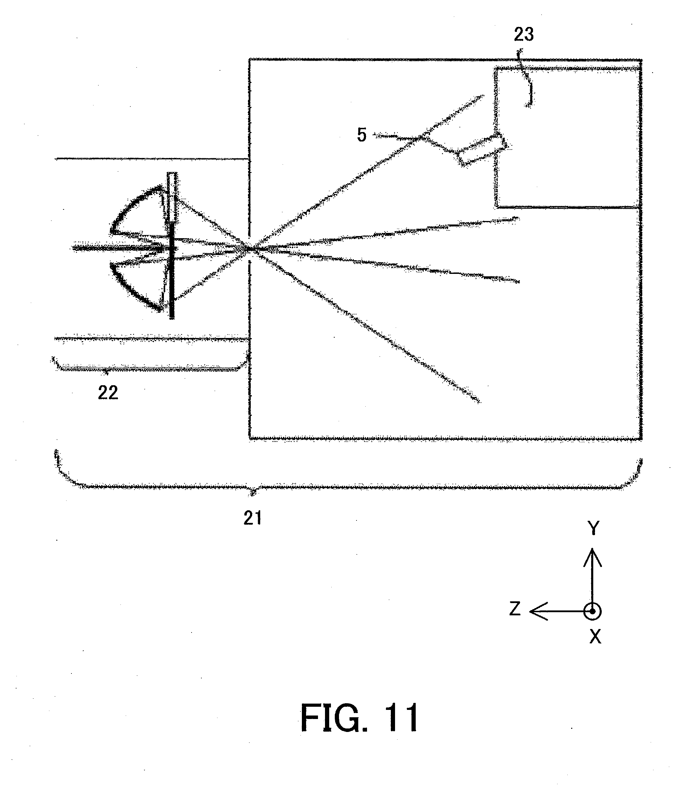

For precise measurements of the light intensity distribution in the EUV light, it is preferable to obtain sensitivities of the plural EUV light detector units used for the above first to fourth embodiments by obtaining their outputs when they measure the EUV light with known light intensity in advance. FIG. 11 is a view showing one exemplary method for measuring the sensitivity of the EUV light detector unit. The EUV light detector units 5 are fixed onto an EUV light detector unit fixing member 23 in an EUV light detector unit sensitivity measuring apparatus 21, EUV light is irradiated onto it from a stable EUV light source 22 that radiates the EUV light with a known light intensity and light intensity distribution, an output of the EUV light detector unit 5 is measured, and the sensitivity is determined.

As discussed, the EUV light intensity distribution measuring apparatus arranges plural EUV light detector units in EUV light to be measured, each of which include a mirror and a photoelectric conversion element, and thus can precisely measure the light intensity in the EUV light. A sufficiently small solid angle of light incident upon the EUV light detector unit to a light source can precisely measure the light intensity distribution of the EUV light having a target wavelength. Moreover, when an incident angle of the EUV light upon the mirror in the EUV light detector unit is set to a Brewster angle of the EUV light, s-polarized component and p-polarized component can be measured in the EUV light.

## Claims

1. A light intensity distribution measuring apparatus for measuring a light intensity distribution in light with a wavelength of 20 nm or smaller emitted from a light source, **characterized in that**:
said light intensity distribution measuring apparatus comprises plural light intensity detector units each including a mirror and a photoelectric conversion element, and measures the light intensity distribution so that an incident angle of the light incident upon the mirror is a predetermined angle.

2. A light intensity distribution measuring apparatus according to claim 1, **characterized in that** the photoelectric conversion element measures the light intensity in a range where a solid angle viewed from the light intensity detector unit to a condensed point of the light is below 0.024 steradians.

3. A light intensity distribution measuring apparatus according to claim 1 or 2, **characterized in that** the light source condenses the light emitted at an emission point and diverges the light at a predetermined divergent angle, and the light intensity detector unit is arranged on a spherical surface that has a center at a condensed point.

4. A light intensity distribution measuring apparatus according to claim 1 or 2, **characterized in that** the light intensity detector unit is arranged on a plane arranged in the light.

5. A light intensity distribution measuring apparatus according to claim 3 or 4, **characterized in that** a surface on which the light intensity detector unit is arranged is rotatable around an optical axis of the light.

6. A light intensity distribution measuring apparatus according to any one of claims 1 to 5, **characterized in that** the incident angle of the light upon the mirror is 20° or smaller in the light intensity distribution detector unit.

7. A light intensity distribution measuring apparatus according to any one of claims 1 to 5, **characterized in that** the incident angle of the light upon the mirror is approximately equal to a Brewster angle for the light in the light intensity distribution detector unit.

8. A light intensity distribution measuring apparatus according to claim 1-5, **characterized in that** the light intensity distribution detector unit has plural mirrors and photoelectric conversion elements corresponding to the respective mirrors, the light incident upon the plural mirrors plural surfaces is orthogonal to plural surfaces that has light reflected by each of the plural mirrors, and the incident angle of the light upon the mirror is approximately equal to a Brewster angle for the light.

9. A light intensity distribution measuring apparatus according to claim 7, **characterized in that** the light intensity distribution detector unit is rotatable by approximately 90° while maintaining the incident angle of the EUV light upon the mirror.

10. A light intensity distribution measuring method that uses a light intensity distribution measuring apparatus for measuring a light intensity distribution of light with a wavelength of 20 nm or smaller emitted from a light source, said light intensity distribution measuring apparatus according to claim 1-9.

11. A light intensity distribution measuring method for measuring a light intensity distribution of light with a wavelength of 20 nm or smaller emitted from a light source, said light intensity distribution measuring method using a light intensity detector unit that includes a mirror and a photoelectric conversion element which are arranged so that an incident angle of the light upon the mirror is approximately equal to a Brewster angle for the light, and said light intensity distribution measuring method measuring the light intensity of the light reflected by the mirror, which light has different directions of polarization by approximately 90° at approximately the same position in the light.

12. A light intensity distribution measuring method according to claim 11, comprising the step of repetitively measuring the light at different measurement positions in the light.

13. Apparatus for measuring the intensity distribution of light from a light source, the apparatus comprising a plurality of light measuring units (5) distributed across the light path, or at least one light measuring unit (5) movable across the light path,
each light measuring unit comprising light detection means (9) and a mirror (7) to reflect light from the light source to the light detection means, and
each of the plurality of light measuring units being arranged so that the respective mirrors of the respective units have the same angle to the light source, or the at least one movable light measuring unit being arranged so that as it moves across the light path its mirror maintains the same angle to the light source.
